# EUROPÄISCHE PATENTANMELDUNG

(11) **EP 2 843 454 A1**
(43) Veröffentlichungstag der Anmeldung: **04.03.2015**
(21) Anmeldenummer: 14181211.5
(22) Anmeldetag: 18.08.2014
(51) Int. Cl.: G02B 7/00, G02B 7/02, G02B 7/18

(54) **Optische Baugruppe mit einer Fassung mit Verbindungseinheiten gerichteter Nachgiebigkeit**

(30) Priorität: 23.08.2013 DE 102013109185
(71) Anmelder: JENOPTIK Optical Systems GmbH, 07745 Jena (DE)
(72) Erfinder: Erbe, Torsten, 07749 Jena (DE); Reichmann, Lutz, 07743 Jena (DE)
(74) Vertreter: Schaller, Renate

(57) **Zusammenfassung**

Die Erfindung betrifft eine thermisch kompensierte optische Baugruppe, umfassend ein rotationssymmetrisches optisches Element (4) und eine monolithische Fassung (1) mit einem rotationssymmetrischen Fassungsring (2), eine Symmetrieachse (2.1) aufweisend, und mindestens drei Verbindungseinheiten (3), über welche das optische Element (4) mit dem Fassungsring (2) verkippungssicher und vorteilhaft verdrehsicher in Verbindung steht.

Die Verbindungseinheiten (3) bestehen aus jeweils drei Koppeln (3.1), (3.2), (3.3), die ein bestimmtes Längenverhältnis zueinander aufweisen und, bestimmte Bedingungen erfüllend, untereinander und mit dem Fassungsring (2) und dem optischen Element (4) verbunden sind.

## Beschreibung

Die Erfindung betrifft eine optische Baugruppe mit einer monolithischen Fassung und einem in dieser gefassten, rotationssymmetrischen optischen Element, wie sie gattungsgemäß aus der Patentanmeldung DE 10 2010 008 756 A1 bekannt ist.

Grundsätzlich werden Fassungen für optische Elemente in Abhängigkeit von den Anforderungen an die Abbildungsqualität sowie den gegebenen Transport-, Lager- und Einsatzbedingungen des optischen Systems, in dem das gefasste optische Element einen Bestandteil bildet, konstruiert. Dabei spielen insbesondere zu erwartende Stoßbelastungen, mögliche Temperaturschwankungen während des Transportes, des Lagerns und des Einsatzes sowie die energetische und spektrale Strahlungsbeeinflussung während des Einsatzes eine Rolle. Das optische Element soll unabhängig von den genannten Belastungen spannungsarm in einer Position dauerhaft gehalten werden.

Aufgrund der genannten Anforderungen an eine erfindungsgemäße Baugruppe werden nachfolgend nur Baugruppen bzw. Fassungen als Bestandteile solcher Baugruppen aus dem Stand der Technik betrachtet, die gleich einer erfindungsgemäßen Baugruppe ein rotationssymmetrisches optisches Element in einer Fassung halten, die über einen vorgegebenen Temperaturbereich einen radialen Dehnungsausgleich ermöglicht. Derartige Baugruppen werden als thermisch kompensiert bezeichnet.

In der Offenlegungsschrift DE 10 2006 060 088 A1 ist eine optische Baugruppe offenbart, mit einer monolithischen Fassung (dort Halterung), in der ein rotationssymmetrisches optisches Element über drei in der Fassung integrierte Verbindungseinheiten in einem Fassungsring gehalten wird. Die Verbindungseinheiten bestehen dort jeweils aus einem an dem optischen Element tangential anliegenden Biegebalken (dort Steg). Durch die radiale elastische Nachgiebigkeit der tangential anliegenden Biegebalken wird das optische Element spannungsarm gehalten und es können unterschiedliche Wärmedehnungen zwischen dem optischen Element und der Fassung ausgeglichen werden. Das optische Element wird dabei stets zentriert gehalten. Die Biegebalken liegen jeweils mittig am Umfang des optischen Elementes an und stehen an ihren beiden Enden mit dem Fassungsring in Verbindung. Im Grundzustand der optischen Baugruppe sind die Biegebalken im Wesentlichen entspannt. Sie werden radial gespannt, wenn sich das optische Element infolge einer Temperaturänderung radial dehnt. Nachteilig an diesem Prinzip der Fassungsgestaltung mit tangential an dem optischen Element anliegenden Biegebalken ist insbesondere, dass äußere Krafteinwirkungen auf die Fassung, die nicht in radialer Richtung auf die Verbindung zwischen Biegebalken und optischem Element wirken, zu unkontrollierten, irreversiblen Verlagerungen des optischen Elementes, insbesondere zu Verdrehungen um dessen optische Achse, führen können.

Auch aus der DE 10 2010 008 756 A1 ist eine optische Anordnung mit einer monolithischen Fassung und einem darin über drei integrierte Verbindungseinheiten (dort Federbeinanordnungen) gehaltenen rotationssymmetrischen optischen Element bekannt. Die Federbeinanordnungen sind jeweils aus zwei Parallelfederbeinen gebildet, wobei jeweils eines der Enden beider Parallelfederbeine über Festkörpergelenke mit einem Fassungsring (dort äußerer Fassungsbereich) verbunden ist und die anderen Enden in einen Kontaktfuß münden, an dem das optische Element durch Klebung oder Lötung fixiert ist. Die beiden Parallelfederbeine sind in Richtung ihrer Nachgiebigkeit, das heißt senkrecht zur optischen Achse des optischen Elementes, mit einem Abstand zueinander angeordnet, der im Verhältnis zu ihrer Länge klein ist, und verlaufen aus Sicht des optischen Elementes entlang einer konkaven Krümmungslinie. Bei einer radialen Ausdehnung des optischen Elementes übt dieses auf die Kontaktfüße radial wirkende Kräfte aus, was zur Auslenkung der Parallelfederbeine in einer senkrechten Ebene zur optischen Achse führt. Dabei würde vergleichsweise zur mittigen Verbindung eines Biegebalkens mit dem optischen Element gemäß der vorbenannten DE 10 2006 060 088 A1 kein Biegemoment im Kontaktbereich mit dem optischen Element entstehen, was sich damit erklären würde, dass die Federbeinanordnung selbst ein Moment im Kontaktbereich erzeugen würde, das dem von dem optischen Element ausgeübten Drehmoment entgegenwirken würde, was dazu führen würde, dass der Kontaktfuß nur eine translatorische Bewegung ausführen kann.

Bei einer unterschiedlichen Ausdehnung des optischen Elementes und der Fassung würde lediglich eine zu vernachlässigende, geringfügige Drehung des optischen Elementes um dessen optische Achse erzeugt werden. Da die Verbindung zwischen den Federbeinanordnungen und dem optischen Element nicht belastet wird, kann sie vorteilhaft stoffschlüssig ausgeführt werden. Nachteilig an diesem Prinzip der Fassungsgestaltung ist, dass eine in Form einer solchen Federbeinanordnung gestaltete Verbindungseinheit viel Raum einnimmt und damit nur dreifach angeordnet werden kann.

Bei beiden vorbenannten Fassungen sind die Verbindungseinheiten als Federgelenke ausgeführt, die eine nur geringe Federsteifigkeit in einer senkrechten Ebene zur Symmetrieachse der Fassung aufweisen, in der bei zentrierter Anordnung eines rotationssymmetrischen optischen Elementes dessen optische Achse liegt, damit das optische Element spannungsarm gehalten werden kann. Aufgrund der gewünschten geringen Federsteifigkeit der Federgelenke in einer Wirkungsrichtung ist die Federsteifigkeit wenigstens auch in einem angrenzenden Bereich um diese Wirkungsrichtung verhältnismäßig gering, was insbesondere zu einer Verdrehung der Federgelenke in sich führen kann, die eine Verkippung der optischen Achse des optischen Elementes zur Symmetrieachse der Fassung zur Folge hat.

Es wurde auch in beiden Schriften darauf hingewiesen, dass die Ausführung der Fassungen als monolithische Bauteile lediglich vorteilhaft ist und Fassungen basierend auf den gezeigten Prinzipien auch durch diskrete Bauteile realisierbar sind.

Der Erfindung liegt die Aufgabe zugrunde, eine thermisch kompensierte optische Baugruppe, umfassend eine Fassung und ein gefasstes optisches Element, zu schaffen, wobei das optische Element verkippungssicher gehalten wird. Vorteilhaft soll die optische Baugruppe so ausgelegt sein, dass kein Drehmoment auf das optische Bauteil wirkt, womit das optische Element auch verdrehsicher gehalten wird.

Diese Aufgabe wird für eine optische Baugruppe, umfassend ein rotationssymmetrisches optisches Element und eine monolithische Fassung mit einem rotationssymmetrischen Fassungsring, eine Symmetrieachse aufweisend, und mindestens drei Verbindungseinheiten, über welche das optische Element mit dem Fassungsring in Verbindung steht, gelöst, indem die Verbindungseinheiten aus drei miteinander verbundenen Koppeln bestehen, wobei eine erste Koppel eine erste Länge, eine zweite Koppel eine zweite Länge, gleich der 2,5-fachen ersten Länge, und eine dritte Koppel eine dritte Länge, gleich der 5-fachen ersten Länge, aufweist.

Die erste Koppel ist jeweils durch ein mit dem Fassungsring verbundenes drittes Festkörpergelenk und ein mit der dritten Koppel in Verbindung stehendes erstes Festkörpergelenk begrenzt.

Die zweite Koppel ist jeweils durch ein mit dem Fassungsring verbundenes viertes Festkörpergelenk und ein mit der dritten Koppel in Verbindung stehendes zweites Festkörpergelenk begrenzt.

Die dritte Koppel ist jeweils durch das erste Festkörpergelenk und eine Befestigungsstelle, die mit dem optischen Element in Verbindung steht, begrenzt, wobei jeweils mittig an der dritten Koppel das zweite Festkörpergelenk ausgebildet ist.

Das dritte und vierte Festkörpergelenk sind jeweils in einem Abstand gleich der doppelten ersten Länge zueinander am Fassungsring ausgebildet.

Unter der vereinfachenden Annahme, dass die Koppeln innerhalb des Bewegungsbereiches der Verbindung steif sind, lässt sich die Auslenkung einer beschriebenen Verbindungseinheit mittels eines Getriebeschemas darstellen, bei dem die Befestigungsstelle auf einer ersten Geraden geführt wird, die parallel zu einer zweiten Geraden verläuft, die durch das dritte und vierte Festkörpergelenk gelegt ist.

Vorteilhaft liegen das dritte und vierte Festkörpergelenk auf einer zweiten Geraden, die parallel zu einer durch die Befestigungsstelle und die Symmetrieachse radial zum Fassungsring verlaufenden ersten Geraden verläuft, sodass bei einer Auslenkung der Verbindungseinheiten die Befestigungsstellen jeweils auf einer der ersten Geraden radial zur Symmetrieachse des Fassungsrings geführt werden.

Das optische Element kann vorteilhaft in einer Hilfsfassung gefasst sein, sodass das optische Element mittelbar über die Hilfsfassung mit den Befestigungsstellen in Verbindung steht.

Nachfolgend wird die Erfindung anhand von Ausführungsbeispielen und Zeichnungen näher erläutert. Hierzu zeigen:
- Fig. 1: eine Explosionsdarstellung eines ersten Ausführungsbeispiels einer optischen Baugruppe,
- Fig. 2: eine auf die wesentlichen Merkmale reduzierte Draufsicht einer Fassung einer optischen Baugruppe gemäß Fig. 1,
- Fig. 3a: eine vergrößerte Darstellung eines Ausschnittes einer Verbindungseinheit einer Fassung einer optischen Baugruppe gemäß Fig. 1,
- Fig. 3b: ein Getriebeschema in einer Stellung für eine unausgelenkte Verbindungseinheit gemäß Fig. 3a,
- Fig. 4a: eine vergrößerte Darstellung eines Ausschnittes einer Verbindungseinheit einer Fassung einer optischen Baugruppe gemäß einem zweiten Ausführungsbeispiel,
- Fig. 4b: ein Getriebeschema in einer Stellung für eine unausgelenkte Verbindungseinheit gemäß Fig. 4a,
- Fig. 5: Getriebeschemen in weiteren Stellungen für unausgelenkte Verbindungseinheiten weiterer Ausführungsbeispiele und
- Fig. 6: eine perspektivische Ansicht des ersten Ausführungsbeispiels einer optischen Baugruppe.

Eine erfindungsgemäße Baugruppe umfasst eine monolithische Fassung 1, bestehend aus einem Fassungsring 2 und mindestens drei aus Koppeln und Festkörpergelenken bestehenden Verbindungseinheiten 3, sowie einem mit der Fassung 1 verbundenen optischen Element 4.

Grundsätzlich könnte eine erfindungsgemäße Fassung 1 auch aus einem Fassungsring 2 und Verbindungseinheiten 3 bestehen, die aus diskreten Koppeln und diskreten Drehgelenken, über welche die Koppeln miteinander und mit dem Fassungsring 2 verbunden sind, gebildet werden. Eine derartige Fassung wäre jedoch in der Herstellung insbesondere aufgrund der notwendigen Montageschritte weitaus aufwendiger und in ihrer Funktion, aufgrund der entstehenden Reibung in den Gelenken, schlechter. Als optische Elemente 4 kommen alle mit einer rotationssymmetrischen Umfangsfläche ausgestatteten, abbildenden optischen Elemente wie Linsen und Spiegel infrage, was jedoch die Möglichkeit der Verwendung der Fassung 1 im Zusammenhang mit Filtern oder optischen Scheiben nicht einschränkt.

Alle Ausführungsbeispiele der Baugruppe haben gemeinsam, dass die Fassung 1 aus einem Fassungsring 2 und einer Anzahl von wenigstens drei, bevorzugt gleichen Verbindungseinheiten 3 bestehen, die bevorzugt mit einem gleichen Abstand zueinander angeordnet sind.

Die Verbindungseinheiten 3 weisen identische Längenverhältnisse und identische Verbindungen über Festkörpergelenke auf. Sie umfassen jeweils drei als steif angenommene Koppeln (3.1, 3.2, 3.3) und können durch ein gleiches Getriebeschema dargestellt werden. Die einzelnen Ausführungsbeispiele der Verbindungseinheiten können sich durch die Winkellage der Koppeln zueinander unterscheiden, was sich durch unterschiedliche Stellungen des einen Getriebeschemas darstellen lässt. Sie können auch innerhalb des Fassungsrings 2 unterschiedlich angeordnet sein, was dazu führt, dass die Befestigungsstelle C auf einer ersten Geraden G₁ in einer unterschiedlichen Lage geführt wird, wie später genauer erläutert wird.

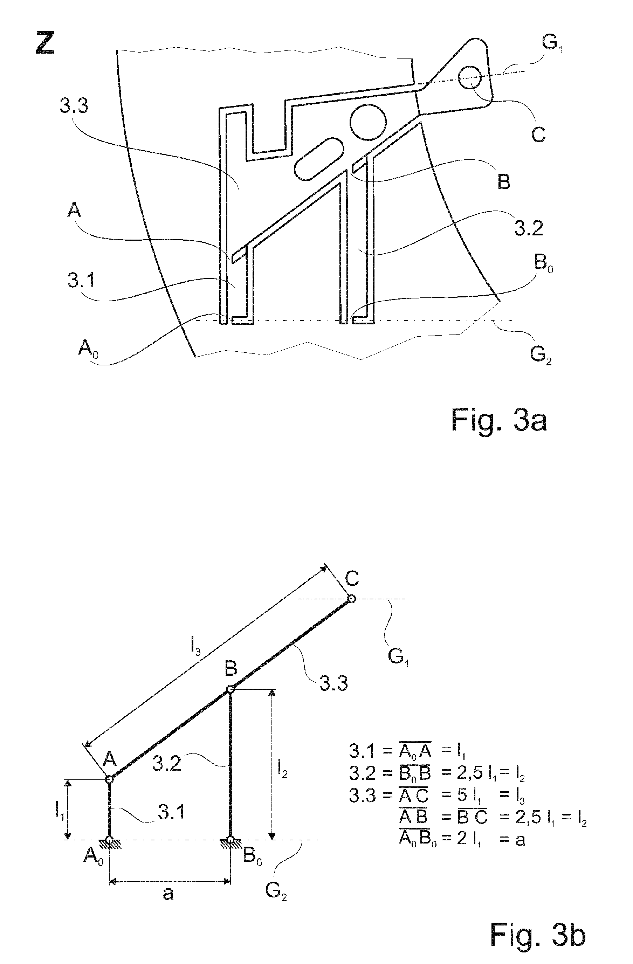

Das die Verbindungseinheiten charakterisierende Getriebeschema, wie es beispielhaft in den Fig. 3b, 4b und 5 in verschiedenen Stellungen gezeigt ist, ist wie folgt dimensioniert.

Eine erste Koppel 3.1 ist durch ein mit dem Fassungsring 2 verbundenes drittes Festkörpergelenk A₀ und ein mit einer dritten Koppel 3.3 in Verbindung stehendes erstes Festkörpergelenk A begrenzt und weist eine erste Länge I₁ auf.

Eine zweite Koppel 3.2 ist durch ein mit dem Fassungsring 2 verbundenes viertes Festkörpergelenk B₀ und ein mit der dritten Koppel 3.3 mittig in Verbindung stehendes zweites Festkörpergelenk B begrenzt und weist eine zweite Länge I₂ gleich dem 2,5-fachen der ersten Länge I₁ auf.

Die dritte Koppel 3.3 ist durch das erste Festkörpergelenk A und eine Befestigungsstelle C begrenzt und weist eine dritte Länge I₃ auf, die gleich dem 5-fachen der ersten Länge I₁ ist. Mittig der dritten Koppel 3.3, die besonders steif ausgeführt ist, ist das zweite Festkörpergelenk B ausgebildet.

Die Einhaltung der genannten Längenverhältnisse ist eine erste zwingende Bedingung für die bestimmungsgemäße Funktion einer erfindungsgemäßen Verbindungseinheit 3, die darin besteht, die Befestigungsstelle C auf der ersten Geraden G₁ zu führen.

Neben der Einhaltung der genannten Längenverhältnisse muss eine zweite zwingende Bedingung erfüllt sein, die darin besteht, dass das dritte und vierte Festkörpergelenk A₀, B₀ in einem Abstand a, gleich der doppelten ersten Länge von I₁, zueinander am Fassungsring 2 ausgebildet sind. Die erste Gerade G₁ verläuft dann parallel zu einer gedachten zweiten Geraden G₂, die durch die Festkörpergelenke A₀, B₀ gelegt ist. Durch die Anordnung des dritten und vierten Festkörpergelenkes A₀, B₀ einer Verbindungseinheit 3 zum Fassungsring 2 wird somit die Lage der Bewegungsbahn der Befestigungsstelle C festgelegt. Mit der Ausdehnung des optischen Elementes 4 werden so die Befestigungsstellen C der einzelnen Verbindungseinheiten jeweils auf einer ersten Geraden G₁ geführt, indem die Verbindungseinheiten 3 ausgelenkt werden. Dabei werden die Koppeln um die Festkörpergelenke geschwenkt.

Vorteilhaft verläuft die erste Gerade G₁ radial zur Symmetrieachse 2.1 des Fassungsrings 2 und damit radial zu einem über die Befestigungsstellen C gefassten optischen Element 4 mit einer rotationssymmetrischen Umfangsfläche. Eine Verschiebung der Befestigungsstellen C, die nur entlang der ersten Geraden G₁ möglich ist, führt dann zu einer geführten, ausschließlich translatorischen und achssymmetrischen Bewegung der Befestigungsstellen C zur Symmetrieachse 2.1 des Fassungsrings 2 hin bzw. von ihr weg.

Eine Verbindungseinheit 3 unterscheidet sich grundsätzlich im Wesentlichen gegenüber solchen aus dem Stand der Technik bekannten Verbindungseinheiten dadurch, dass sie nicht aus Biegebalken besteht, sondern einen Koppelmechanismus, oder auch Koppelgetriebe genannt, darstellt, welches eine geführte, bevorzugt radial geführte Ausgleichsbewegung der Befestigungsstelle C bewirkt.

Die vorangehenden Erläuterungen setzen voraus, dass die Koppeln hinreichend steif sind, dass die Bewegungsbahn der Befestigungsstelle C über ein Getriebeschema eines Koppelgetriebes beschreibbar ist. Da die Koppeln jedoch aufgrund der monolithischen Ausbildung praktisch nur annähernd ausreichend steif sind, beschreibt die Befestigungsstelle C mit ihrer Bewegungsbahn tatsächlich keine ideale, parallel zu einer zweiten Geraden G₂ verlaufende erste Gerade G₁. Insofern die Abweichungen nicht vernachlässigbar sind, können sie wenigstens weitestgehend reduziert werden, indem das dritte und das vierte Festkörpergelenk A₀, B₀ geringfügig versetzt werden, sodass die durch sie gedachte zweite Gerade G₂ nur annähernd parallel zu der ersten Geraden G₁ verläuft. Für eine theoretische Betrachtung der Baugruppe werden die Abweichungen, verursacht durch eine nicht vollständig auszuschließende Biegung der Koppeln, außer Acht gelassen.

Im Zusammenhang mit der Einwirkung von mechanischen und thermischen Einflüssen weist die Baugruppe insbesondere folgende Vorteile auf:

Bei Temperaturveränderungen, die zu ungleicher Ausdehnung des optischen Elementes 4 und der Fassung 1 führen, ist die Relativbewegung zwischen dem optischen Element 4 und der Fassung 1 eine rein translatorische Bewegung der Befestigungsstelle C entlang der gegebenenfalls radial verlaufenden ersten Geraden G₁. Das optische Element 4 erfährt damit kein Drehmoment, was für den Erhalt der Abbildungsqualität des optischen Elementes 4 und den Erhalt einer spannungsarmen, zentrischen Lage sowie mechanischen Stabilität der Verbindung des optischen Elementes 4 mit den Verbindungseinheiten 3 über die Befestigungsstellen C von wesentlicher Bedeutung ist.

Mechanische Deformationen der Fassung 1, die entstehen können, wenn die Fassung 1 z. B. über Halteelemente in einem Gehäuseteil mittels Manipulatoren justiert wird, werden jeweils über das dritte und vierte Festkörpergelenk A₀, B₀ aufgenommen und nicht auf die Befestigungsstellen C übertragen.

Auch von außen auf die Fassung 1 einwirkende Stoßbelastungen werden, sofern sie lokal auf die Fassung 1 einwirken, nicht bzw. maximal durch eine temporäre translatorische Verschiebung der Befestigungsstellen C auf das optische Element 4 übertragen. Die Eigenfrequenz der Verbindungseinheiten 3 ist, vergleichsweise zu solchen aus dem Stand der Technik bekannten Verbindungseinheiten mit Biegeelementen, klein, womit bei Belastungen nur geringe Schwingungsamplituden entstehen können.

Das optische Element 4 wird, bedingt durch die erläuterte Ausführung der Verbindungseinheiten 3, nur durch seine Gewichtskraft und die entgegenwirkenden Haltekräfte sowie symmetrisch, durch ausschließlich radial wirkende Ausgleichskräfte, welche die Lage des optischen Elementes 4 in der Fassung 1 nicht beeinflussen und im Nominalfall identisch null sind, beansprucht.

Das dritte und vierte Festkörpergelenk A₀, B₀ können auch so zum Fassungsring 2 angeordnet sein, dass die erste Gerade G1 nicht radial verläuft. Sofern eine mögliche Verdrehung des optischen Elementes 4 toleriert werden kann bzw. ein zu kompensierender Temperaturbereich so gering ist, dass eine mögliche Verdrehung vernachlässigbar ist, muss dies zu keiner schlechteren Ausführung der optischen Baugruppe führen.

Die Steifigkeit der Verbindungseinheiten 3 in axialer Richtung ist im Vergleich zu den aus Federgelenken bestehenden Verbindungseinheiten sehr hoch, sodass bei maximal zu erwartenden Krafteinwirkungen keine Verdrehung der Verbindungseinheiten 3 erfolgt, die zu einer Verkippung des optischen Elementes 4 führen kann.

Die Steifigkeit kann mit einer zunehmend größeren Anzahl von Verbindungseinheiten 3 noch erhöht werden. Dafür ist es von Vorteil, dass die Verbindungseinheiten 3 verhältnismäßig klein ausgeführt werden können. So können mehr als drei, z. B. sechs Verbindungseinheiten 3 oder auch mehr ausgebildet werden. Die Verbindungseinheiten 3 werden unabhängig von deren Anzahl vorteilhaft gleich und mit einem gleichen Winkelabstand zueinander ausgeführt. Die Verbindungseinheiten 3 ungleich auszuführen oder in einem ungleichen Winkelabstand zueinander anzuordnen, könnte dann von Interesse sein, wenn eine optisch wirksame Fläche des optischen Elementes 4 nicht rotationssymmetrisch sondern z. B. eine Freiformfläche ist. Eine zunehmend größere Anzahl als drei, insbesondere sechs, ergibt auch eine vorteilhafte, über den Umfang des optischen Elementes 4 verteilte Kräfteübertragung und eine steifere Anbindung des optischen Elementes an die Fassung, insbesondere bei mechanischen Einwirkungen auf die Fassung 1 von außen. Somit wird die Gefahr von Verspannungen des optischen Elementes 4 mit einer größeren Anzahl von Verbindungseinheiten 3 herabgesetzt. Die verhältnismäßig nur kurzen und steifen Koppeln 3.1, 3.2 und 3.3 führen zu einer erwünschten hohen axialen Steifigkeit der Fassung 1.

Bei der Herstellung von monolithischen Fassungen werden mittels unterschiedlicher Technologien in einen Fassungskörper Schnitte eingebracht, womit der Fassungskörper in den Fassungsring und die Verbindungseinheiten unterteilt wird. Die Lage und Dimension der damit gebildeten Koppeln und Festkörpergelenke wird durch die Schnittführung bestimmt, womit es auf einfache Weise möglich ist, insbesondere die Dicke der Koppeln in einer senkrechten Ebene zur Symmetrieachse und damit ihre Steifigkeit sowie die Steifigkeit der Festkörpergelenke in dieser Ebene über die Schnittführung festzulegen.

Nachfolgend sollen zwei Ausführungsbeispiele für die Verbindungseinheiten näher erläutert werden.

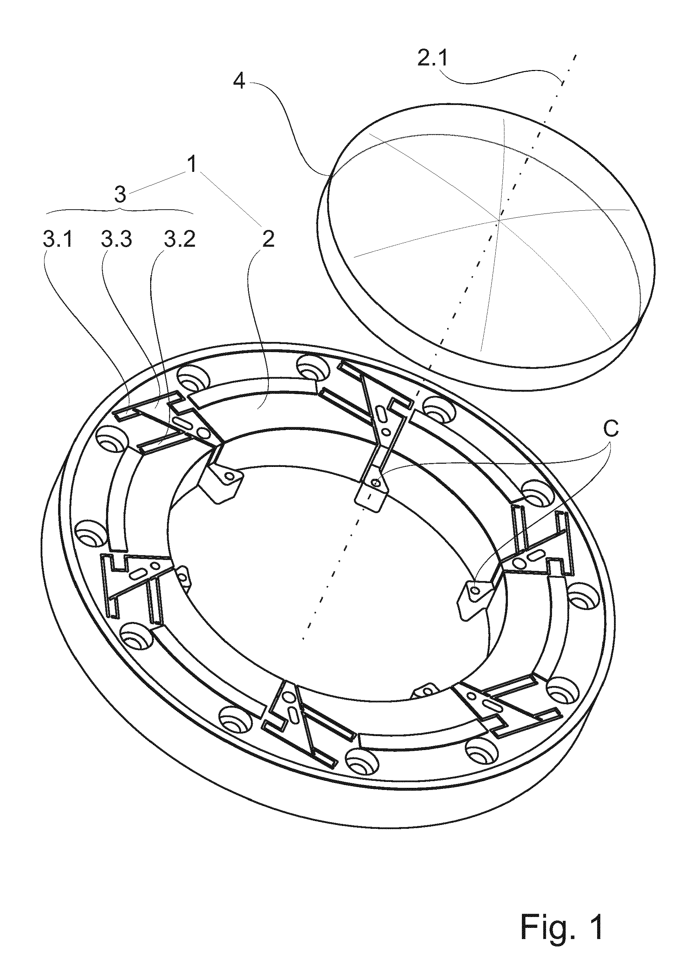

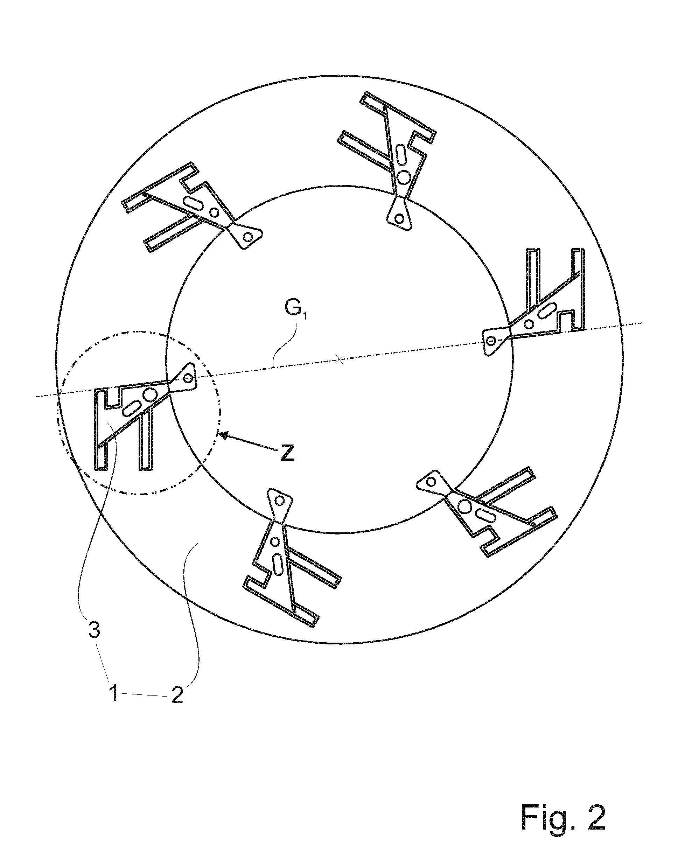

Eine erfindungsgemäße Fassung 1, gemäß einem ersten Ausführungsbeispiel, umfassend einen Fassungsring 2 mit sechs Verbindungseinheiten 3, ist in einer konkreten Ausführung in den Fig. 1 und 2 gezeigt. In Fig. 3a ist ein vergrößerter Ausschnitt aus der Fassung 1 mit einer Verbindungseinheit 3 dargestellt.

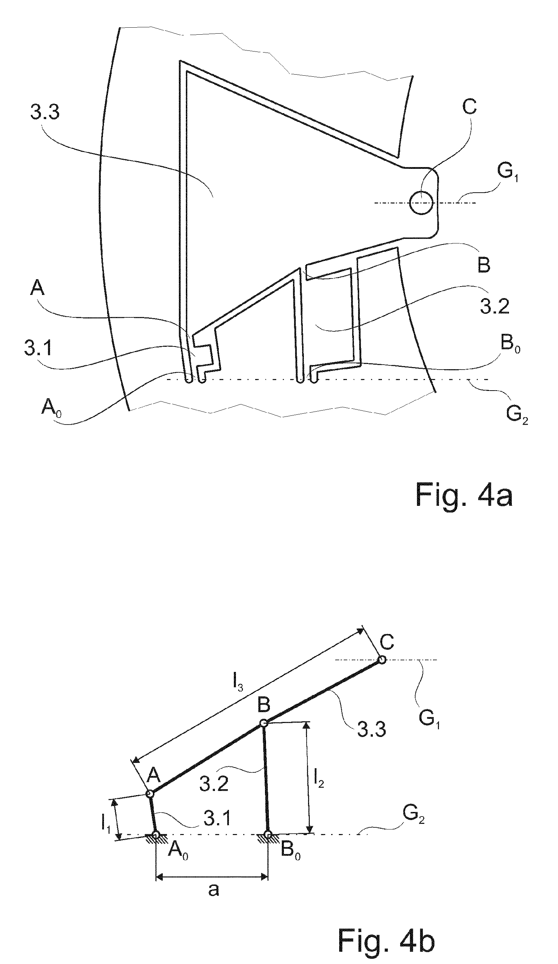

Eine erfindungsgemäße Fassung 1, gemäß einem zweiten Ausführungsbeispiel, umfassend einen Fassungsring 2 mit vier Verbindungseinheiten 3, ist in einer konkreten Ausführung ausschnittsweise in Fig. 4a gezeigt.

In beiden Ausführungsbeispielen sind die erste Koppel 3.1 und die zweite Koppel 3.2 der Verbindungseinheiten 3 vorteilhaft parallel zueinander angeordnet, was z. B. eine Prüfbarkeit der Längen vereinfacht. Die Verbindungseinheiten der Ausführungsbeispiele unterscheiden sich in dem Winkel, den die Koppeln 3.1, 3.2 mit der dritten Koppel 3.3 einschließen und in der Steifigkeit der Koppeln 3.1, 3.2, 3.3, indem die des zweiten Ausführungsbeispiels massiver ausgeführt sind. Des Weiteren hat das zweite Ausführungsbeispiel eine kleinere radiale Ausdehnung, sodass die Fassung mit einem kleineren Außendurchmesser ausgeführt werden kann, wenn man von der Annahme ausgeht, dass der nicht durch Schlitze geschwächte Bereich der Fassung eine Mindestbreite haben soll.

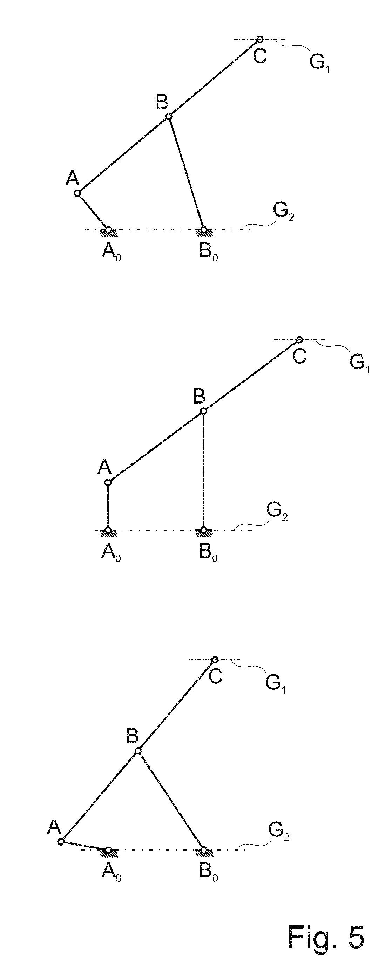

Gemäß dem zweiten Ausführungsbeispiel ist die dritte Koppel großflächiger ausgebildet, was günstiger sein kann, um dort Befestigungselemente, z. B. einen Klemmbügel zum Fixieren des optischen Elementes 4 anzubringen. An der dritten Koppel 3.3 angebrachte Elemente ändern die Lage zum optischen Element 4 nicht. Weitere Ausführungsbeispiele, wie sie z. B. durch die Stellungen des Getriebeschemas, gezeigt in Fig. 5, beschrieben werden können, weisen erste und zweite Koppeln 3.1, 3.2 auf, die nicht parallel zueinander verlaufen.

Wie in Fig. 1 gut erkennbar, sind die Befestigungsstellen C als Auflageklötzchen ausgebildet, die sich in den ansonsten freien Innendurchmesser des Fassungsrings 2 erstrecken. Das optische Element 4 ist auf diesen Auflageklötzchen aufliegend, bevorzugt stoffschlüssig mit den Auflageklötzchen verbunden. Es kann aber auch über eine mittelbare formschlüssige oder form- und kraftschlüssige Verbindung, wie eine Schraubverbindung, hier fixiert sein.

Fig. 1 zeigt auch auf einer Kreislinie verteilte längliche Erhebungen, die als Anlagefläche für eine in einem optischen System benachbart angeordnete Fassung dienen. Durch den nur kleinen Bauraum, den die Verbindungseinheiten jeweils beanspruchen, ist hierfür ausreichend Platz gegeben. Es verbleibt auch ausreichend Platz um z. B., wie ebenfalls in Fig. 1 gezeigt, im Randbereich des Fassungsrings 2 Durchgangsbohrungen vorzusehen, über welche die Fassung 1 z. B. an ein Gehäuseteil montiert werden kann. Auf die Darstellung dieser für die Erfindung nicht wesentlichen Merkmale der Fassung 1 wurde in Fig. 2 der Übersichtlichkeit halber verzichtet.

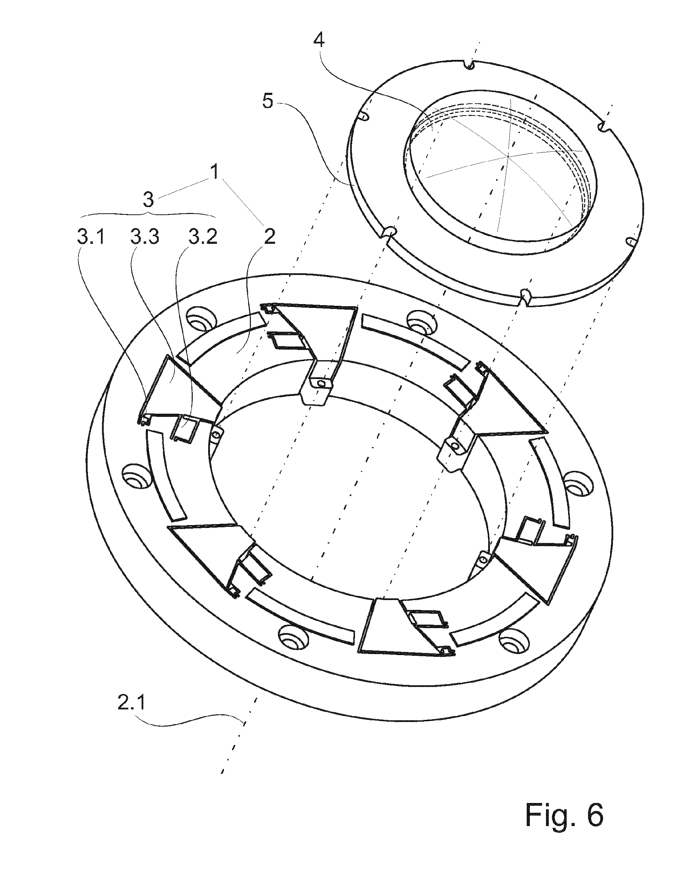

Das optische Element 4 kann unmittelbar oder mittelbar über eine Hilfsfassung 5, wie in Fig. 6 gezeigt, mit den Verbindungseinheiten 3 verbunden sein. Insbesondere, wenn das optische Element 4 selbst keinen rotationssymmetrischen Umfang aufweist oder benachbart angeordnete Elemente einen deutlich größeren Außendurchmesser aufweisen, kann es in einer rotationssymmetrischen Hilfsfassung 5 gehalten sein, die dann ihrerseits mit den Verbindungseinheiten 3 der Fassung 1 verbunden ist.

Das optische Element 4 bzw. das in einer Hilfsfassung 5 gehaltene optische Element 4 kann stoffschlüssig, z. B. durch Kleben, Löten, form- oder kraftschlüssige Klemmungen (z. B. Verstiften, Nieten, Schrauben, Klemmung mithilfe weiterer Elemente), an die Verbindungseinheit 3 angebunden sein. Dabei ist es günstig, wenn die Anbindung in oder wenigstens in unmittelbarer Nähe zur Befestigungsstelle C liegt, z. B. durch eine Gewindebohrung in diesem Punkt.

### Bezugszeichenliste

- 1: Fassung
- 2: Fassungsring
- 2.1: Symmetrieachse
- 3: Verbindungseinheit
- 3.1: erste Koppel
- 3.2: zweite Koppel
- 3.3: dritte Koppel
- 4: optisches Element
- 5: Hilfsfassung

- A: erstes Festkörpergelenk
- B: zweites Festkörpergelenk
- A₀: drittes Festkörpergelenk
- B₀: viertes Festkörpergelenk
- C: Befestigungsstelle
- I₁: erste Länge
- I₂: zweite Länge
- I₃: dritte Länge
- G₁: erste Gerade
- G₂: zweite Gerade
- a: Abstand

## Patentansprüche

1. Optische Baugruppe umfassend ein rotationssymmetrisches optisches Element (4) und eine monolithische Fassung (1) mit einem rotationssymmetrischen Fassungsring (2), eine Symmetrieachse (2.1) aufweisend, und mindestens drei Verbindungseinheiten (3), über welche das optische Element (4) mit dem Fassungsring (2) in Verbindung steht, **dadurch gekennzeichnet, dass**
die Verbindungseinheiten (3) jeweils aus einer ersten Koppel (3.1) mit einer ersten Länge (I₁), einer zweiten Koppel (3.2) mit einer zweiten Länge (I₂), gleich der 2,5-fachen ersten Länge (I₁), und einer dritten Koppel (3.3) mit einer dritten Länge (I₃), gleich der 5-fachen ersten Länge (I₁), gebildet sind,
wobei die erste Koppel (3.1) jeweils durch ein mit dem Fassungsring (2) verbundenes drittes Festkörpergelenk (A₀) und ein mit der dritten Koppel (3.3) in Verbindung stehendes erstes Festkörpergelenk (A) begrenzt ist,
die zweite Koppel (3.2) jeweils durch ein mit dem Fassungsring (2) verbundenes viertes Festkörpergelenk (B₀) und ein mit der dritten Koppel (3.3) in Verbindung stehendes zweites Festkörpergelenk (B) begrenzt ist,
die dritte Koppel (3.3) jeweils durch das erste Festkörpergelenk (A) und eine Befestigungsstelle (C), die mit dem optischen Element (4) in Verbindung steht, begrenzt ist, wobei
jeweils mittig an der dritten Koppel (3.3) das zweite Festkörpergelenk (B) ausgebildet ist,
und dass das dritte und vierte Festkörpergelenk (A₀,), (B₀) in einem Abstand (a), gleich der doppelten ersten Länge (I₁), zueinander am Fassungsring (2) ausgebildet sind.

2. Optische Baugruppe nach Anspruch 1, **dadurch gekennzeichnet,**
**dass** das dritte und vierte Festkörpergelenk (A₀, B₀) jeweils auf einer zweiten Geraden (G₂) liegen, die parallel zu jeweils einer durch die Befestigungsstelle (C) und die Symmetrieachse (2.1) radial zum Fassungsring (2) verlaufenden ersten Gerade (G₁) verläuft, sodass bei einer Auslenkung der Verbindungseinheiten (3) die Befestigungsstellen (C) jeweils auf einer der ersten Geraden (G₁) radial zur Symmetrieachse (2.1) des Fassungsrings (2) geführt werden.

3. Optische Baugruppe nach Anspruch 1, **dadurch gekennzeichnet, dass**
das optische Element (4) in einer Hilfsfassung (5) gefasst ist, sodass das optische Element (4) mittelbar über die Hilfsfassung (5) mit den Befestigungsstellen (C) in Verbindung steht.
